# EUROPEAN PATENT SPECIFICATION

(11) **EP 1 468 332 B1**
(45) Date of publication and mention of the grant of the patent: **31.03.2010**
(21) Application number: 03703957.5
(22) Date of filing: 23.01.2003
(51) Int. Cl.: G03F 7/004

(54) **PHOTOSENSITIVE COMPOSITION AND PHOTOSENSITIVE PLANOGRAPHIC PRINTING PLATE**
FOTOEMPFINDLICHE ZUSAMMENSETZUNG UND FOTOEMPFINDLICHE FLACHDRUCKPLATTE
COMPOSITION PHOTOSENSIBLE ET PLAQUE D'IMPRESSION PLANOGRAPHIQUE PHOTOSENSIBLE

(30) Priority: 24.01.2002 JP 2002016039
(43) Date of publication of application: 20.10.2004
(73) Proprietor: Kodak Polychrome Graphics Company Ltd., Norwalk, Connecticut 06851 (US)
(72) Inventor: MORI, Takanori, Tatebayashi-shi, Gunma-ken (JP); KAMIYA, Masamichi, Gunma-ken (JP)
(74) Representative: Vossius & Partner
(86) International application number: PCT/US2003/001921
(87) International publication number: WO 2003/062924

(56) References cited:
- EP-A- 0 379 166
- EP-A- 0 762 208
- JP-A- 2001 312 053

## Description

### Field of the Invention

The present invention relates to a photosensitive composition that can used to form photosensitive planographic printing plates and photoresists and, more particularly, to a photosensitive composition that yields a coating film having excellent coating film uniformity and excellent inking properties, and to a photosensitive planographic printing plate comprising the composition.

### Background of the Invention

A planographic printing plate used in offset printing comprises a support and a photosensitive layer made of a photosensitive composition provided on the support, and includes, for example, a positive-working photosensitive planographic printing plate comprising a photosensitive layer made of a photosensitive composition comprising a resin such as novolac resin and a photosensitive compound such as quinonediazide compound, and negative-working photosensitive planographic printing plate comprising a photosensitive layer made of a photosensitive composition comprising a resin and a photosensitive diazonium compound or a photosensitive composition comprising a resin, an ethylenically unsaturated compound and a radical polymerization initiator.

An image is formed by dissolving the exposed area of the photosensitive layer in a developer in the case of the positive-working photosensitive planographic printing plate, while an image is formed by dissolving the non-exposed area of the photosensitive layer in a developer in the case of the negative-working photosensitive planographic printing plate: The area insoluble in the developer serves as an image area which receives ink, while the area, in which the support is exposed as a result of the dissolution of the photosensitive layer, serves as a non-image area which receives water to repel oil-based ink. A planographic printing process is a process of printing utilizing a difference in receptivity of oil-based ink.

In the production of photosensitive planographic printing plates, sometimes referred to as printing plate precursors, a coating solution prepared by dissolving or dispersing a photosensitive composition in a solvent is applied on a support and the photosensitive composition is dried by drying air blowing to form a photosensitive layer. However, unevenness of the photosensitive layer is caused by drying air flow upon drying air blowing and linear irregularities occur upon coating or drying, and thus the thickness of the photosensitive layer became non-uniform. When the thickness of the photosensitive layer becomes non-uniform, not only does the appearance become inferior, but also light exposure and development become non-uniform, and the reproducibility of an original pattern might be reduced. Furthermore, sufficient press-life and sufficient image intensity are sometimes not obtained.

Therefore, according to the invention described in Japanese Patent Application, First Publication No. Sho 62-170950, by mixing a photosensitive composition with a fluorosurfactant having a fluoroaliphatic group whose carbon atom at the end is fluorinated and a poly(oxyalkylene) group, the surface tension of the photosensitive composition is reduced to make the thickness of the photosensitive layer uniform.

Also Japanese Patent Application, First Publication No. 2000-131832 proposes to mix a photosensitive composition with a silicone surfactant having a polar moiety made of polyorganosiloxane and a poly(oxyalkylene) group.

However, the thickness was not made to be satisfactorily uniform, although a slight improvement was obtained even if the fluorosurfactant or silicone surfactant is contained in the photosensitive composition. Furthermore, the fluorosurfactant or silicone surfactant has a poly(oxyalkylene) group as a hydrophilic group and, when the photosensitive layer contains such a surfactant, inking with oil-based ink is not easily performed in the planographic printing plate. Therefore, at the beginning of printing, a large loss in printed sheets occurred until ink was completely transferred onto a printing paper. Moreover, considerable time is required until normal printing is conducted and therefore the productivity of printing is lowered.

In the field of the coating composition, various leveling agents for improving the fluidity of the coating composition have been proposed (for example, Japanese Patent Application, First Publication No. Hei 2-232271, and PPCJ, Vol. 188, No. 4408, Pages 18,20 and 22 (1998), Juckel H). However, the photosensitive layer exhibited insufficient uniformity of the thickness even if these leveling agents are used in the photosensitive composition. Similar to the fluorosurfactant or silicone surfactant, these leveling agents have hydrophilicity and therefore inking is not easily performed.

### Summary of the Invention.

In one aspect, the invention is a photosensitive composition that improves both thickness uniformity and inking properties. In another aspect, the invention a photosensitive planographic printing plate containing the composition.

The photosensitive composition comprises a silicone surfactant and/or a fluorosurfactant, and an acrylic copolymer having a monomer unit represented by the following general formula (1):

- [CH₂-CR¹ (COOR²) -] **General Formula (1)**

wherein R¹ represents H or CH₃ and R² represents a polyester or polyether chain.

It is preferred that the acrylic polymer further have a monomer unit represented by the following general formula (2):

[CH₂-CR³ (COOR⁴) -] **General Formula (2)**

wherein R³ represents H or CH₃ and R⁴ represents an alkyl or phenylalkylene group having 1 to 30 carbon atoms.

The polyester or polyether chain preferably has a molecular weight of 200 to 3000.

The photosensitive composition can further comprise an o-quinonediazide compound. Alternatively, the photosensitive composition can further comprise a photosensitive diazonium compound. Alternatively, the photosensitive composition can further comprise an ethylenically unsaturated compound and a radical polymerization initiator. Alternatively, the photosensitive composition can further comprise a photothermal converting agent. Alternatively, the photosensitive composition can further comprise a compound that generates an acid by heat, an acid crosslinking agent and a photothermal converting agent.

A photosensitive planographic printing plate comprising a support and a photosensitive layer made of the above photosensitive composition provided on the surface of the support.

### Detailed Description of the Invention

The photosensitive composition comprises an acrylic copolymer having a monomer unit of the above general formula (1) (hereinafter referred to as an acrylic copolymer), and a silicone surfactant and/or a fluorosurfactant.

### Acrylic copolymer

In the acrylic copolymer, R¹ in the monomer unit of the general formula (1) is H or CH₃ and R² is a polyester or polyether chain. As described above, when R¹ in the general formula (1) is H or CH₃ and R² is a polyester or polyether chain, leveling properties of the coating solution of the photosensitive composition can be sufficiently improved.

More preferably, the acrylic polymer further has a monomer unit of the general formula (2). In the general formula (2), R³ is H or CH₃ and R⁴ is an alkyl or phenylalkylene group having 1 to 30 carbon atoms. As described above when R³ in the general formula (2) is H or CH₃ and R⁴ is an alkyl or phenylalkylene group having 1 to 30 carbon atoms, the liphophilicity of the photosensitive layer is improved and the receptivity of the oil-based ink is improved, and thus inking properties are further improved.

Furthermore, the polyester or polyether chain of the acrylic polymer preferably has a molecular weight of 200 to 3000. When the molecular weight is less than 200, leveling properties of the coating solution of the photosensitive composition may not be improved. On the other hand, when the molecular weight exceeds 3000, inking properties may be lowered because of too high hydrophilicity of the photosensitive layer.

### Silicone surfactant

The silicone surfactant is not specifically limited as long as it has a nonpolar moiety made of polyorganosiloxane and a polar moiety containing an oxygen atom and, for example, there can be used polyether-modified polyorganosiloxane, alcohol-modified polyorganosiloxane and carboxyl-modified polyorganosiloxane. Specific examples of the silicone surfactant include BYK-333 (manufactured by BYK Chemie) as polyether-modified polydimethylsiloxane.

The silicone surfactant has a hydrophilic group and a lipophilic group and, when the photosensitive composition contains the silicone surfactant, the surface tension of the coating solution of the photosensitive composition is lowered and the wettability on the support is improved. As a result, the coating film becomes uniform.

### Fluorosurfactant

Examples of the fluorosurfactant include, for example, anionic fluorosurfactants such as perfluoroalkyl group-containing carboxylate, perfluoroalkyl group-containing sulfonate, perfluoroalkyl group-containing sulfate ester salt and perfluoroalkyl group-containing phosphate; cationic fluorosurfactants such as perfluoroalkyl group-containing amine salt and perfluoroalkyl group-containing quaternary ammonium salt; amphoteric fluorosurfactants such as perfluoroalkyl group-containing carboxybetaine and perfluoroalkyl group-containing aminocarboxylate; and perfluoroalkyl group-containing oligomer, perfluoroalkyl group-containing polymer and perfluoroalkyl group-containing sulfonamide polyethylene glycol adduct.

Similar to the case of the silicone surfactant, when the photosensitive composition contains the fluorosurfactant, the surface tension of the coating solution of the photosensitive composition is lowered and the wettability on the support is improved. As a result, the coating film becomes uniform.

The total content of the silicone surfactant and the fluorosurfactant in the photosensitive composition is preferably within a range from 0.01 to 10% by weight. When the total content is less than 0.01% by weight, the coating film may not become sufficiently uniform because the surface tension of the coating solution of the photosensitive composition cannot be sufficiently lowered. On the other hand, when the total content exceeds 10% by weight, the cost increases.

### Photosensitive compositions

Examples of the photosensitive compositions containing the acrylic polymer, the fluorosurfactant and/or the silicone surfactant described above include, but are not limited to, (1) positive-working photosensitive compositions containing an o-quinonediazide compound, (2) negative-working photosensitive composition containing a photosensitive diazonium compounds, (3) negative-working photosensitive compositions containing an ethylenically unsaturated compound and a radical polymerization initiator, (4) positive-working photosensitive compositions containing a photothermal converting agent capable of being activated by infrared laser (for CTP) and (5) negative-working photosensitive compositions containing a compound which generates an acid by heat, an acid crosslinking agent and a photothermal converting agent, capable of being activated by infrared laser (for CTP). The photosensitive compositions (1) to (5) will now be described in order.

### (1) Positive-working photosensitive compositions containing o-quinonediazide compounds

The o-quinonediazide compound is preferably a compound having at least one o-quinonediazide group wherein the solubility in an aqueous alkali solution increases by active light ray. Compounds having various structures are known and are described in detail on pages 336-352 of "Light-Sensitive Systems" (John Wiley & Songs, Inc., 1965), edited by J. KOSAR.

As the o-quinonediazide compound, sulfonate esters of various hydroxyl compounds and o-benzoquinonediazide or o-naphthoquinonediazide are particularly preferred.

Examples of the o-quinonediazide compound include ester of 1,2-naphthoquinone-2-diazide-5-sulfonyl chloride and a phenol-formaldehyde resin or cresol-formaldehyde resin; ester of 1,2-naphthoquinone-2-diazide-5-sulfonyl chloride and a pyrogallol-acetone resin described in U.S. Patent No. 3,635,709; ester of 1,2-naphthoquinone-2-diazide-5-sulfonyl chloride and a resorcinolbenzaldehyde resin described in Japanese Patent Application, Second Publication No. Sho 63-13528; ester of 1,2-naphthoquinone-2-diazide-5-sulfonyl chloride and a resorcinol pyrogallol-acetone polycondensed resin described in Japanese Patent Application, Second Publication No. Sho 62-44257; compound obtained by esterifying a polyester having a hydroxyl group at the terminus with 1,2-naphthoquinone-2-diazide-5-sulfonyl chloride described in Japanese Patent Application, Second Publication No. Sho 56-45127; compound obtained by esterifying a homopolymer of N-(4-hydroxyphenyl)methacrylamide or a copolymer of the other copolymerizable monomer with 1,2-naphthoquinone-2-diazide-5-sulfonyl chloride described in Japanese Patent Application, Second Publication No. Sho 50-24641; ester of 1,2-naphthoquinone-2-diazide-5-sulfonyl chloride and a bisphenol-formaldehyde resin described in Japanese Patent Application, Second Publication No. Sho 54-29922; compound obtained by esterifying a homopolymer of p-hydroxystyrene or a copolymer of the other copolymerizable monomer with 1,2-naphthoquinone-2-diazide-5-sulfonyl chloride described in Japanese Patent Application, Second Publication No. Sho 52-36043; and ester of 1,2-naphthoquinone-2-diazide-5-sulfonyl chloride and polyhydroxybenzophenone.

Other examples of the publicly known o-quinonediazide compounds include those described in Japanese Patent Application, First Publication No. Sho 63-80254, Japanese Patent Application, First Publication No. Sho 58-5737, Japanese Patent Application, First Publication No. Sho 57-111530, Japanese Patent Application, First Publication No. Sho 57-111531, Japanese Patent Application, First Publication No. Sho 57-114138, Japanese Patent Application, First Publication No. Sho 57-142635, Japanese Patent Application, First Publication No. Sho 51-36129, Japanese Patent Application, Second Publication No. Sho 62-3411, Japanese Patent Application, Second Publication No. Sho 62-51459, Japanese Patent Application, Second Publication No. Sho 51-483, Japanese Patent Application, First Publication No. Hei 10-198030, Japanese Patent Application, First Publication No. Hei 11-143066, Japanese Patent Application, First Publication No. Hei 11-242325 and Japanese Patent Application, First Publication No. Hei 11-305429.

The content of the o-quinonediazide compound is preferably within a range from 5 to 60% by weight, and more preferably from 10 to 40% by weight, based on the total solid content of the photosensitive composition.

The positive-working photosensitive composition can contain an alkali-soluble resin. Examples of the alkali-soluble resin include novolac resin or resol resin such as phenol-formaldehyde resin, m-cresol-formaldehyde resin, p-cresol-formaldehyde resin, m-/p-mixed cresol-formaldehyde resin, phenol/cresol (m-, p-, or m-/p-mixed) -mixed formaldehyde resin, phenol-formaldehyde resin, or resorcinol-formaldehyde resin; polyhydroxystyrene; acrylic resin described in Japanese Patent Application, First Publication No. Hei 1-35558, Japanese Patent Application, First Publication No. Hei 2-866, Japanese Patent Application, First Publication No. Hei 8-339080 or Japanese Patent Application, First Publication No. Hei 8-339082; and urethane resin described in Japanese Patent Application, First Publication No. Sho 63-124047. The photosensitive composition of the present invention has a feature such that development latitude is further widened by using these publicly known resins in combination, and a novolac resin is used particularly preferably in the combination with a quinonediazide compound. Preferably, the number-average molecular weight of the alkali-soluble resin is within a range from 200 to 20,000 and the weight-average molecular weight is within a range from 300 to 60,000.

In the positive-working photosensitive composition, cyclic acid anhydrides to enhance the sensitivity, print-out agents to obtain visible images immediately after light exposure, dyes as image coloring agents and other fillers can be added, if necessary.

Examples of the cyclic acid anhydride include succinic anhydride, glutaric anhydride, itaconic anhydride, phthalic anhydride, tetrahydrophthalic anhydride, hexahydrophthalic anhydride, maleic anhydride, chloromaleic anhydride and pyromellitic anhydride. These cyclic acid anhydrides can be added in the amount within a range from 1 to 15% by weight based on the entire composition.

Examples of the print-out agent to obtain visible images immediately after exposure to light include combination of a photosensitive compound which releases an acid upon exposure to light and an organic dye which, together with an acid, forms a salt to change color tone.

Examples of the photosensitive compound which generates an acid upon exposure to light include o-naphthoquinonediazide-4-sulfonic acid halogenide described in Japanese Patent Application, First Publication No. Sho 50-36209; trihalomethyl-2-pyrone or trihalomethyl-s-triazine described in Japanese Patent Application, First Publication No. Sho 53-36223; various o-naphthoquinodiazide compounds described in Japanese Patent Application, First Publication No. Sho 55-62444; 2-trihalomethyl-5-aryl-1,3,4-oxadiazole compound described in Japanese Patent Application, First Publication No. Sho 55-77742; and diazonium salt. These compounds can be used alone or in combination and the amount is preferably within a range from 0.3 to 15% by weight based on the total weight of the composition.

Examples of the organic dye capable of forming a salt include triphenylmethane dye, cyanine dye, diazo dye and styryl dye and specific examples thereof include Crystal Violet, Ethyl Violet, Methyl Violet, Methylene Blue, Victoria Blue BH, Victoria Pure Blue BOH, Malachite Green, Oil Blue #603, Oil Green BG, Brilliant Green, fuchsin, eosin, Rhodamine B, Oil Pink #312, Oil Red 5B, Oil Black BS, Oil Yellow #101, phenolphthalein, Cresol Red, auramine, Leucocrystal Violet and Leucomalachite Green. The amount is preferably within a range from 0.3 to 15% by weight based on the total weight of the composition.

In the positive-working photosensitive composition, there can be added various additives for the purposes, for example, various resins having a hydrophobic group to improve inking properties of the image, such as octylphenol-formaldehyde resin, t-butylphenol-formaldehyde resin, t-butylphenol-benzaldehyde resin, rosin-modified novolac resin, and o-naphthoquinonediazide sulfonate esters of these modified novolac resin; and plasticizers to improve the pliability of the coating film, such as butyl phthalate, dioctyl phthalate, butyl glycolate, tricresyl phosphate and dioctyl adipate. The amount is preferably within a range from 0.01 to 30% by weight based on the total weight of the composition.

### (2) Negative-working photosensitive compositions containing photosensitive diazonium compounds

The photosensitive diazonium compound includes, for example, a diazo resin represented by a salt of a condensate of diazodiarylamine and an active carbonyl compound.

Examples of preferred diazo resin include organic acid salts or inorganic acid salts of condensates of 4-diazodiphenylamine, 4-diazo-3-methyldiphenylamine, 4-diazo-4'-methyldiphenylamine, 4-diazo-3'-methyldiphenylamine, 4-diazo-4'-methoxydiphenylamine, 4-diazo-3-methyl-4'-ethoxydiphenylamine or 4-diazo-3-methoxydiphenylamine, and formaldehyde, paraformaldehyde, acetaldehyde, benzaldehyde or 4,4'-bis-methoxymethyl diphenyl ether.

Examples of the organic acid of the diazo resin include methanesulfonic acid, benzenesulfonic acid, toluenesulfonic acid, xylenesulfonic acid, mesitylenesulfonic acid, dodecylbenzenesulfonic acid, naphthalenesulfonic acid, propylnaphthalenesulfonic acid, 1-naphthol-5-sulfonic acid, 2-nitrobenzenesulfonic acid, 3-chlorobenzenesulfonic acid and 2-hydroxy-4-methoxybenzophenone-5-sulfonic acid, and examples of the inorganic acid include hexafluorophosphoric acid, tetrafluoroboric acid and thiocyanic acid.

Furthermore, a diazo resin wherein a principal chain is a polyester group described in Japanese Patent Application, First Publication No. Sho 54-30121; a diazo resin obtained by reacting a polymer having a carboxylic anhydride residue with a diazo compound having a hydroxyl group described in Japanese Patent Application, First Publication No. Sho 61-273538; and a diazo resin obtained by reacting a polyisocyanate compound with a diazo compound having a hydroxyl group can be used.

The amount of these diazo resins is preferably within a range from 5 to 40% by weight based on the solid content of the composition and, if necessary, two or more diazo kinds of resins may be used in combination.

In the negative-working photosensitive composition, there can be used, as a binder resin, copolymers such as (meth)acrylic acid-(meth)acrylate ester copolymer, copolymer containing hydroxyalkyl (meth)acrylate- and (meth)acrylonitrile, having an acid value of 10 to 100 described in U.S. Patent No. 4,123,276, copolymer having an aromatic hydroxyl group described in Japanese Patent Application, Second Publication No. Sho 57-43890 and copolymer having a 2-hydroxy-3-phenoxypropyl (meth)acrylate unit described in Japanese Patent Application, Second Publication No. Sho 57-51656; epoxy resin; polyamide resin; vinyl halide, particularly polyvinyl chloride or polyvinylidene chloride; polyvinyl acetate; polyester; acetal resins such as formal resin and butyral resin; soluble polyurethane resins which are commercially available from Goodrich U.S.A under the trade name of ESTANE®; polystyrenes; styrene-maleic anhydride copolymers or semi-esters thereof; cellulose derivatives; shellac; rosins or modified compounds thereof; and copolymers having an unsaturated group in the side chain described in Japanese Patent Application, First Publication No. Sho 61-285449.

Examples of other resins that can be used in the negative-working photosensitive compositions include polymers of α,β-unsaturated carboxylic acids such as acrylic acid, methacrylic acid, ethacrylic acid, maleic anhydride, methylmaleic anhydride, phenylmaleic anhydride, crotonic acid, itaconic acid and vinylbenzoic acid; polymers of crotonic acid, itaconic acid and vinylbenzoic acid; polymers of α,β-unsaturated sulfonic acids such as allylsulfonic acid, vinylsulfonic acid and vinylbenzenesulfonic acid; polymers having a phenolic hydroxyl group; polymers having a sulfoamide group; and polymers having an active imino group. The above polymers may be copolymerized with a monomer other than an α,β-unsaturated organic acid. Examples of the monomer other than the α,β-unsaturated organic acid include acrylate esters, methacrylate esters, acrylamides, methacrylamides, allyl compounds, vinyl ethers and vinyl esters.

The resin, which can be developed with an alkali developer, preferably further has any of an alcoholic hydroxyl group, a cyano group and a urea group.

In the negative-working photosensitive composition, publicly known additives such as dyes, pigments, plasticizers and stability modifiers can be added to improve the performances.

Examples of preferred dye include basic oil-soluble dyes such as Crystal Violet, Malachite Green, Victoria Blue, Methylene Blue, Ethyl Violet and Rhodamine B. Examples of the commercially available product thereof include "Victoria Pure Blue BOH" (manufactured by Hodogaya Chemical Co., Ltd.) and "Oil Blue #603" (manufactured by Orient Chemical Industries, Ltd.). Examples of the pigment include Phthalocyanine Blue, Phthalocyanine Green, Dioxadine Violet and Quinacridon Red.

Examples of the plasticizer include diethyl phthalate, dibutyl phthalate, dioctyl phthalate, tributyl phosphate, trioctyl phosphate, tricresyl phosphate, tri(2-chloroethyl) phosphate and tributyl citrate.

As publicly known stability modifiers, for example, phosphoric acid, phosphorous acid, oxalic acid, tartaric acid, malic acid, citric acid, dipicolinic acid, polyacrylic acid, benzenesulfonic acid and toluenesulfonic acid can be used in combination.

The amount of these additives varies depending on the purposes, but is preferably 30% by weight or less based on the solid content of the photosensitive composition.

### (3) Negative-working photosensitive compositions containing ethylenically unsaturated compounds and radical polymerization initiators

The ethylenically unsaturated compound is a monomer or oligomer that has a boiling point under normal pressure of 100°C or higher and also has at least one, preferably 2 or more addition-polymerizable ethylenically unsaturated groups in a molecule. Examples of the monomer or oligomer include monofunctional (meth)acrylates such as polyethylene glycol mono(meth)acrylate (hereinafter methacrylate and acrylate are generically referred to as (meth)acrylate), polypropylene glycol mono(meth)acrylate and phenoxyethyl (meth)acrylate; and polyfunctional (meth)acrylates such as polyethylene glycol di(meth)acrylate, polypropylene glycol di(meth)acrylate, trimethylolpropane tri(meth)acrylate, neopentyl glycol di(meth)acrylate, pentaerythritol tri(meth)acrylate, pentaerythritol tetra(meth)acrylate, dipentaerythritol hexa(meth)acrylate, hexanediol di(meth)acrylate, tri(acyloyloxyethyl) isocyanurate, (meth)acrylate of polyhydric alcohol-alkylene oxide adduct, (meth)acrylate of polyhydric phenol-alkylene oxide adduct, urethane acrylates described in Japanese Patent Application, Second Publication No. Sho 48-41708, Japanese Patent Application, Second Publication No. Sho 50-6034 and Japanese Patent Application, Second Publication No. Sho 51-37193, polyester acrylates described in Japanese Patent Application, First Publication No. Sho 48-64183, Japanese Patent Application, Second Publication No. Sho 49-43191 and Japanese Patent Application, Second Publication No. Sho 52-30490, and epoxy acrylates obtained by the addition reaction between an epoxy resin and (meth)acrylic acid.

The amount of these compounds having an addition-polymerizable ethylenically unsaturated group is preferably within a range from 5 to 70% by weight based on the solid content of the composition.

Such an ethylenically unsaturated compound can be photopolymerized by using a radical polymerization initiator. As the radical polymerization initiator, photoinitiators known from patents and references, or combinations (photoinitiation systems) of a radical polymerization initiator and a sensitizing pigment can be appropriately selected and used according to the wavelength of the light source used. When using light having a wavelength of about 400 nm as the light source, benzyl, benzoin ether, Michler's ketone, anthraquinone, thioxanthone, acridine, phenazine and benzophenone are widely used.

When using a visible-light or near-infrared-light laser having a wavelength of 400 nm more as the light source, various photoinitiation systems using the radical polymerization initiator in combination with the sensitizing pigment have been proposed. The radical polymerization initiator is not specifically limited and may be any as long as it can form active species, which are required to subject the addition-polymerizable compound component having an ethylenically unsaturated double bond in the photopolymerizable composition of the present invention to the polymerization reaction, by means of the energy or electron transfer reaction from the sensitizing pigment which absorbed visible light or near infrared light energy. Examples of the radical polymerization initiator used in the present invention include bisimidazole compounds such as 2,2'-bis(o-chlorophenyl)-4,4',5,5'-tetraphenyl-1,1'-bisimidazole and 2,2'-bis(o-chlorophenyl)-4,4',5,5'-tetrakis(2,3-dimethoxyphenyl)-1,1'-bisimidazole; 2,4,6-substituted-1,3,5-triazine compounds such as 2,4,6-tris(trichloromethyl)-1,3,5-triazine, 2-methyl-4,6-bis(trichloromethyl)-1,3,5-triazine, 2-phenyl-4,6-bis(trichloromethyl)-1,3,5-triazine, 2,4-bis(trichloromethyl)-6-(p-methoxyphenylvinyl)-1,3,5-triazine and 2-(4'-methoxy-1'-naphthyl)-4,6-bis(trichloromethyl)-1,3,5-triazine; onium salt compounds such as diaryliodonium salt and triallylsulfonium salt obtained by using diphenyliodonium, 4,4'-dichlorodiphenyliodonium, 4,4'-dimethoxydiphenyliodonium, 4,4'-di-t-butyldiphenyliodonium, 4-methyl-4'-isopropyldiphenyliodonium or 3,3'-dinitrodiphenyliodonium in combination with chloride, bromide, tetrafluoroborate, hexafluorophosphate, hexafluoroarsenante, hexafluoroantimonate, tetrakis(pentafluorophenyl) borate or trifluoromethanesulfonic acid; metal arene complexes such as titanocene and ferrocene; benzoin ether compounds such as benzyl, benzoin, benzoin alkyl ether and 1-hydroxycyclohexyl phenyl ketone; ketal compounds such as benzyl alkyl ketal; acetophenone compounds such as 2,2'-dialkoxyacetophenone, 2-hydroxy-2-methylpropiophenone, p-t-butyltrichloroacetophenone and p-t-butylcycloacetophenone; benzophenone compounds such as benzophenone, 4-chlorobenzophenone, 4,4'-dichlorobenzophenone, methyl o-benzoylbenzoate, 3,3'-dimethyl-4-methoxybenzophenone and 4-benzoyl-4'-methyldiphenyl sulfide, dibenzosuberone; thioxanthone compounds such as thioxanthone, 2-chlorothioxanthone, 2-alkylthioxanthone and 2,4-dialkylthioxanthone; anthraquinone compounds; peroxides such as 3,3',4,4'-tetra(t-butylperoxycarbonyl)benzophenone; and N-arylglycine compounds such as N-phenylglycine, N-(p-chlorophenyl)glycine, N-hydroxyethyl-N-phenylglycine and N-(2-hydroxy-3-methacryloxypropyl)-N-phenylglycine. In the present invention, two or more kinds of these radical polymerization initiators may be optionally used in combination.

The sensitizing pigment can absorb visible light or near infrared light. Examples of the sensitizing pigment include azo pigment, anthraquinone pigment, benzoquinone pigment, naphthoquinone pigment, diaryl and triarylmethane pigment, cyanine pigment, merocyanine pigment, fluoran pigment, squarylium pigment, croconium pigment, pyrylium pigment, thiopyrylium pigment, phthalocyanine derivative, naphthalocyanine derivative, indigo pigment, cumarin pigment, ketocumarin pigment, quinacridon pigment, quinophthalon pigment, pyrrolopyrrole pigment, benzodifuranone pigment, acridine pigment, oxazine pigment, thiazine pigment, xanthene pigment, thioxanthenepigment, styryl pigment, spiropyran pigment, spirooxazine pigment and organic rutenium complex. As the sensitizing pigment, any pigment described in already-known publications such as "Functional Pigments" (1992, Kodansha Scientific), edited by Makoto OHGAWARA, et al.; "Chemistry and Application of Pigments" (1994, Dainippon Tosho), edited by Ken MATSUOKA; and "Pigment Handbook" (1986, Kodansha), edited by "Makoto OHGAWARA, et al.". In the photopolymerizable composition of the present invention, two or more kinds selected from the above sensitizing systems or pigments can be optionally used in combination as the sensitizing pigment to absorb light having a corresponding wavelength.

The total amount of the radical polymerization initiator and sensitizing pigment is preferably within a range from 0.5 to 20% by weight based on the solid content of the composition.

In the negative-working photosensitive composition, publicly known additives such as dyes, pigments, plasticizers and stability modifiers can be added to improve the performances similar to the above negative-working photosensitive composition (2).

The amount of these additives varies depending on the purposes, but is preferably from 0 to 30% by weight based on the solid content of the photosensitive composition.

The features of the negative-working photosensitive compounds (2) and (3) are that, when using a photosensitive diazonium compound, the resulting printing plate is excellent in adhesion between a photosensitive layer and a support is excellent and that, when using an ethylenically unsaturated compound in combination with a radical polymerization initiator, a tough coating film can be obtained by exposure. When using a photosensitive diazonium compound, an ethylenically unsaturated compound and a radical polymerization initiator in combination, a coating film having two features described above.

In the negative-working photosensitive composition, there can be used, as the binder resin, copolymers such as (meth)acrylic acid-(meth)acrylate ester copolymer, copolymer containing hydroxyalkyl (meth)acrylate and (meth)acrylonitrile, which an acid value of 10 to 100 described in U.S. Patent No. 4,123,276, copolymer having an aromatic hydroxyl group described in Japanese Patent Application, Second Publication No. Sho 57-43890 and polymer having a 2-hydroxy-3-phenoxypropyl (meth)acrylate unit described in Japanese Patent Application, Second Publication No. Sho 57-51656; epoxy resins; polyamide resins; vinyl halides, particularly polyvinyl chloride and polyvinylidene chloride; polyvinyl acetates; polyesters; acetal resins such as formal resin and butyral resin; soluble polyurethane resins which are commercially available from Goodrich U.S.A under the trade name of ESTANE®; polystyrenes; styrene-maleic anhydride copolymers or semi-esters thereof; cellulose derivatives; shellac; rosins or modified compounds thereof; and copolymers having an unsaturated group in the side chain described in Japanese Patent Application, First Publication No. Sho 61-285449.

### (4) Positive-working photosensitive compositions containing photothermal converting agents, capable of being activated by infrared laser

The photothermal converting agent is a substance which has a light absorption range in a near infrared to infrared range having a wavelength within a range from 700 to 3000 nm, preferably 750 to 1200 nm, and absorbs light to generate heat. Examples of the substance include various pigments and dyes.

As the pigment in the present invention, commercially available pigments can be employed. Examples of the pigment include black pigment, yellow pigment, orange pigment, brown pigment, red pigment, violet pigment, blue pigment, green pigment, fluorescent pigment and the other polymer bonded pigment. Specifically, there can be used insoluble azo pigment, azo lake pigment, condensed azo pigment, chelate azo pigment, phthalocyanine pigment, anthraquinone pigment, perylene and perinone pigment, thioindigo pigment, quinacridon pigment, dioxazine pigment, isoindolinone pigment, quinophthalon pigment, dyeing lake pigment, azine pigment, nitroso pigment, nitro pigment, natural pigment, fluorescent pigment, inorganic pigment and carbon black.

Among these pigments, carbon black is preferably used as a substance that absorbs light in a near infrared to infrared range to efficiently generate heat and is economically superior.

These pigments may be used without subjecting to a surface treatment, or may be used after subjecting to a publicly known surface treatment. Examples of the method for publicly known surface treatment include a method of coating the surface with a resin or wax, a method of coating with a surfactant, and a method of depositing a reactive substance such as silane coupling agent, epoxy compound or polyisocyanate on the surface of the pigment.

The particle diameter of the pigment used in the present invention is preferably within a range from 0.01 to 15 micrometer, and more preferably from 0.01 to 5 micrometer. A grafted carbon black, the dispersibility in the dispersion solvent of which was improved by the graft polymerization, is particularly preferably used in the photosensitive composition of the present invention.

Examples of the dye used in the present invention include cyanine dye, squarylium dye, croconium dye, azulenium dye, phthalocyanine dye, naphthalocyanine dye, polymethine dye, naphthoquinone dye, thiopyrylium dye, dithiol metal complex dye, anthraquinone dye, indoaniline dye and intermolecular CT dye. Specific examples of the dye include compounds described in Japanese Patent Application, First Publication No. Sho 59-202829, Japanese Patent Application, First Publication No. Sho 58-194595, Japanese Patent Application, First Publication No. Sho 60-63744, Japanese Patent Application, First Publication No. Sho 58-112792, Japanese Patent Application, First Publication No. Sho 57-142645, Japanese Patent Application, First Publication No. 2000-310852, Japanese Patent Application, First Publication No. 2000-199950 and Japanese Patent Application, First Publication No. 2000-131837.

Examples of the commercially available product include IR750 (anthraquinone compounds) which are commercially available from Nippon Kayaku Kabushiki Kaisha; IR002 and IR003 (aluminum compounds); IR820 (polymethine compound); IRG022 and IRG033 (diimmonium compounds); CY-2, CY-4, CY-9 and CY-20; KIR103 and SIR103 (phthalocyanine compounds) which are commercially available from Mitsui Chemicals; KIR101 and SIR114 (anthraquinone compounds); PA1001, PA1005, PA1006 and SIR128 (metal complex compounds); Fastogen Blue 8120 which are commercially available from DAINIPPON INK & CHEMICALS, Inc.; MIR-101, 1011 and 1021 manufactured by Midori Chemical Co., Ltd.; Pro-JET 825LDI, Pro-JET 830DI, S-175139/1, S-175139/2, S-175140/5, S-175140/6, S-178376/1 and S-189632/1 which are commercially available from AVECIA; S-0094, S-0121, S-0229, S-0253, S-0260, S-0270, S-0306, S-0322, S-0325, S-0337, S-0345, S-0378, S-0389, S-0391, S-0402, S-0447, S-0450, S-0484, S-0492 and S-0585 which are commercially available from FEW; and compounds which are commercially available from Nihon Kanko Shikiso Co., Ltd., Sumitomo Chemical Industries Co., Ltd. and Fuji Photo Film Co., Ltd.

As the photothermal converting agent, a proper pigment or dye, which can absorb light having a specific wavelength from the light source below and convert light into heat, can be used by appropriately selecting from the above pigments or dyes.

When using the pigment or dye as the photothermal converting agent, the amount is preferably within a range from 0.01 to 50% by weight, and particularly preferably from 0.1 to 20% by weight, based on the total solid content of the positive-working photosensitive composition. When the amount of the pigment is less than 0.01% by weight, the developer resistance of the image area is lowered. On the other hand, when the amount is more than 50% by weight or more, the developability of the non-image area (exposed area) is lowered. Therefore, it is not preferred.

These photothermal converting agents generally have an action of substantially lowering the solubility in an aqueous alkali solution of a photosensitive composition containing a photosensitive resin and imparts the resistance to the alkali developer to the non-exposed area.

Another compound having an action of reducing the solubility in the aqueous alkali solution of the photosensitive composition containing a photosensitive resin may also be used in combination. Examples of the compound include an onium salt, aromatic sulfone compound, aromatic sulfonate ester compound, phosphate ester compound, aromatic carboxylate ester compound, aromatic disulfone compound, aromatic ketone compound, aromatic aldehyde compound, aromatic ether compound and o-quinonediazide compound.

The positive-working photosensitive composition contains an alkali-soluble resin. Examples of the alkali-soluble resin include novolac resin or resol resin such as phenol-formaldehyde resin, m-cresol-formaldehyde resin, p-cresol-formaldehyde resin, m-/p-mixed cresol-formaldehyde resin, phenol/cresol (m-, p-, or m-/p-mixed)-mixed formaldehyde resin, phenol-formaldehyde resin, or resorcinol-formaldehyde resin; polyhydroxystyrene; acrylic resin described in Japanese Patent Application, First Publication No. Hei 1-35558, Japanese Patent Application, First Publication No. Hei 2-866, Japanese Patent Application, First Publication No. Hei 8-339080 or Japanese Patent Application, First Publication No. Hei 8-339082; and urethane resin described in Japanese Patent Application, First Publication No. Sho 63-124047. The photosensitive composition of the present invention has a feature such that development latitude is further widened by using these publicly known resins in combination, and a novolac resin is used particularly preferably in the combination with a quinonediazide compound. Preferably, the number-average molecular weight of the alkali-soluble resin is within a range from 200 to 20,000 and the weight-average molecular weight is within a range from 300 to 60,000.

In the positive-working photosensitive composition capable of being activated by infrared laser, there can be optionally added publicly known additives, for example, cyclic acid anhydrides to enhance the sensitivity, print-out agents to obtain visible images immediately after exposure, dyes as image coloring agents, various resins having a hydrophobic group to improve inking properties of the image, plasticizers to improve the pliability of the coating film, and publicly known resins added to improve the wear resistance of the coating film.

Examples of the cyclic acid anhydride include succinic anhydride, glutaric anhydride, itaconic anhydride, phthalic anhydride, tetrahydrophthalic anhydride, hexahydrophthalic anhydride, maleic anhydride, chloromaleic anhydride, trimellitic anhydride and pyromellitic anhydride. The amount is preferably 15% by weight or less, based on the photosensitive composition.

The print-out agent to obtain visible images immediately after exposure includes, for example, combination of a heat-sensitive compound which releases an acid upon exposure to high-density energy light, and an organic dye which forms a salt with an acid to change the color tone.

Examples of the heat-sensitive compound, which releases an acid upon exposure to high-density energy light, include latent Brønsted acids described in Japanese Patent Application, First Publication No. Hei 7-20629; an acid precursor described in Japanese Patent Application, First Publication No. Hei 8-220752; a compound which can generate an acid upon exposure to activating light described in Japanese Patent Application, First Publication No. Hei 9-171254; a compound which generates an acid by heat described in Japanese Patent Application, First Publication No. Hei 9-211863; compounds which generate an acid upon exposure to activating light or emitted radiation described in Japanese Patent Application, First Publication No. Hei 9-211864 and Japanese Patent Application, First Publication No. Hei 9-211865; and an onium borate complex described in Japanese Patent Application, First Publication No. Hei 9-304931. The amount is preferably 15% by weight or less, based on the photosensitive composition.

Examples of the organic dye, which, together with an acid, can form a salt, include triphenylmethane dye, cyanine dye, diazo dye and styryl dye. Specific examples thereof include Crystal Violet, Ethyl Violet, Methyl Violet, Methylene Blue, Victoria Blue BH, Victoria Pure Blue BOH, Oil Blue #603, Malachite Green, Oil Green BG, Brilliant Green, fuchsin, eosin, Rhodamine B, Oil Pink #312, Oil Red 5B, Oil Black BS, Oil Yellow #101, phenolphthalein, Cresol Red, auramine, Leucocrystal Violet and Leucomalachite Green. The amount is 15% by weight or less based on the photosensitive composition.

Examples of the dye as the image coloring agent include stilbene dye, benzophenone dye, benzoquinone dye, naphthoquinone dye, squarylium dye, oxidation dye, sulfide dye, reactive dye and fluorescent whitening dye. The amount is 15% by weight or less based on the positive-working photosensitive composition.

Examples of various resins having a hydrophobic group to improve inking properties of the image include octylphenol-formaldehyde resin, t-butylphenol-formaldehyde resin, t-butylphenol-benzaldehyde resin, rosin-modified novolac resin, and esters of these modified novolac resins.

Examples of the plasticizer to improve the pliability of the coating film include diethyl phthalate, dioctyl phthalate, butyl glycolate, tricresyl phosphate and dioctyl adipate.

Examples of the publicly known resin added to improve the wear resistance of the coating film include polyvinyl acetal resin, polyurethane resin, epoxy resin, vinyl chloride resin, nylon, polyester resin and acrylic resin.

The amount of these additives is usually 15% by weight or less based on the positive-working photosensitive composition and the total amount is 40% by weight or less.

### (5) Negative-working photosensitive compositions containing a compound that generates an acid by heat, an acid crosslinking agent and a photothermal converting agent, capable of being activated by an infrared laser

The negative-working photosensitive composition capable of being activated by infrared laser is generally composed of a combination of a compound that generates an acid by heat, an acid crosslinking agent, a photothermal converting agent, and an alkali-soluble resin. Examples of the compound that generates an acid by heat include publicly known onium salts such as ammonium salt, phosphonium salt, iodonium salt, sulfonium salt or selenonium salt, organic halogen compound, photo acid generator having an o-nitrobenzyl type protective group, and disulfone compound. Particularly, a trihaloalkyl compound and a diazonium salt compound can be preferably used because high sensitivity can be obtained. If necessary, two or more kinds of compounds, which generate an acid by heat, may be used in combination.

Examples of the trihaloalkyl compound include a trihalomethyl-s-triazine compound described in U.S. Patent No. 4,239,850, and an oxadiazole compound and a tribromomethylsulfonyl compound described in U.S. Patent No. 4,212,970.

As the diazonium salt compound, the above photosensitive diazonium compound can be used.

The amount of the compound that generates an acid by heat is preferably within a range from 0.01 to 50% by weight, and particularly preferably from 0.1 to 20% by weight, based on the solid content of the negative-working photosensitive composition. When the amount of the compound that generates an acid by heat is less than 0.01 % by weight, it is impossible to expect the sufficient generation of an acid to crosslink with an acid crosslinking agent. On the other hand, when the amount exceeds 50% by weight, the solubility in developer of the non-image area is drastically lowered.

The acid crosslinking agent is not specifically limited and may be any as long as it is crosslinked and made to be insoluble by the catalytic action of the acid generated from the compound which generates an acid by heat.

Examples of the acid crosslinking agent include amino compounds having at least two groups among methylol group, alkoxymethyl group and acetoxymethyl group. Specific examples thereof include melamine derivative such as methoxymethylated melamine, benzoguanamine derivative or glycol uril derivative, urea resin derivative, and resol resin.

Among these, a resol resin is preferably used because the solubility of the image area/non-image area in the developer, and contrast are enhanced.

The amount of the acid crosslinking agent is preferably within a range from 5 to 70% by weight based on the solid content of the negative-working photosensitive composition. If necessary, two or more kinds of compound (b), which are crosslinked with an acid, may be used in combination.

As the photothermal converting agent, pigments or dyes described as for the positive-working photosensitive composition capable of being activated by infrared laser (4) can be used.

The amount of the photothermal converting agent is preferably within a range from 3 to 20% by weight based on the solid content of the negative-working photosensitive composition. When the amount of the photothermal converting agent is less than 3% by weight, a sufficient amount of heat cannot be generated even if it absorbs light to generate heat. On the other hand, when the amount exceeds 20% by weight, the amount of heat generated is substantially saturated and the addition effect is not enhanced. Therefore, it is not preferred.

In the negative-working photosensitive composition, examples of the binder resin include novolac resins and resol resins, such as phenol-formaldehyde resin, cresol-formaidehyde resin and phenol-cresol-formaldehyde polycondensed resin; polyhydroxystyrene; polyhalogenated hydroxystyrene; acrylic resin containing one or more kinds of monomers having an acid group, such as N-(4-hydroxyphenyl)methacrylamide, hydroquinone monomethacrylate, N-(sulfamoylphenyl) methacrylamide, N-phenylsulfonyl methacrylamide, N-phenylsulfonylmaleimide, acrylic acid or methacrylic acid; active methylene group-containing resin described in Japanese Patent Application, First Publication No. Sho 63-127237; vinyl polymerized resin such as urea bond-containing resin described in Japanese Patent Application, First Publication No. Hei 8-339082; polyurethane resin having an N-sulfonylamide group, an N-sulfonylureido group or an N-aminosulfonylamide group described in Japanese Patent Application, First Publication No. Sho 63-261350; polyurethane resins such as active imide group-containing polyurethane resin described in Japanese Patent Application, First Publication No. Hei 2-77748; and polyester resins such as polyester resin having a phenolic hydroxyl group described in Japanese Patent Application, First Publication No. Hei 6-236029.

In the negative-working photosensitive composition capable of being activated by infrared laser, publicly known additives, for example, dyes as image coloring agents, plasticizers and stability modifiers can be optionally added similar to the above negative-working photosensitive composition (2).

The amount of these various additives varies depending on the purposes, but is preferably within a range from 0 to 30% by weight based on the solid content of the photosensitive composition.

As described above, leveling properties are improved because the photosensitive composition described above contains an acrylic polymer having a monomer unit of the general formula (1). Because the photosensitive composition contains a silicone surfactant and/or a fluorosurfactant, the surface tension of the coating solution of the photosensitive composition is lowered and the wettability on the support is improved. Therefore, unevenness is not caused by drying air flow upon drying air blowing and linear irregularities do not occur upon coating, and thus the uniformity of the coating film is improved.

A combination of the fluorosurfactant or silicone surfactant and the acrylic polymer, by which the effect of improving inking properties was not expected, surprisingly improves inking properties. It was not anticipated at all that such an effect would occur by using the fluorosurfactant or silicone surfactant in combination with the acrylic polymer and also the reason for exertion of such an effect is not resolved. The reason is believed to be as follows.

That is, inking properties are improved when the acrylic polymer is distributed at the upper portion in the photosensitive layer in the presence of the silicone surfactant or fluorosurfactant.

When the acrylic polymer further has a monomer unit of the general formula (2) in which R³ is H or CH₃ and R⁴ is an alkyl or phenylalkylene group having 1 to 30 carbon atoms, the lipophilicity of the photosensitive layer is appropriately improved and the ink receptivity is improved, and thus inking properties are further improved.

Furthermore, the polyester or polyester chain of the acrylic polymer has a molecular weight of 200 to 3000, the uniformity and inking properties of the coating film can be simultaneously improved to a sufficient level.

### Photosensitive planographic printing plate

The photosensitive planographic printing plate of the present invention is generally composed of a support and a photosensitive layer made of the above photosensitive composition provided on the support.

The photosensitive layer made of the photosensitive composition capable of being activated by infrared laser may be referred to as a heat-sensitive layer because it utilizes heat generated upon exposure to light, but is referred to as a photosensitive layer for convenience.

Examples of the support include metal plates made of aluminum, zinc, copper, stainless steel and iron; plastic films made of polyethylene terephthalate, polycarbonate, polyvinyl acetal and polyethylene; composite materials obtained by providing a metal layer on a paper or plastic film melt-coated with a synthetic resin or coated with a synthetic resin solution using a technology such as vacuum deposition or lamination; and materials used as the support of the printing plate. Among these supports, an aluminum support and a composite support coated with aluminum are preferred.

The surface of the aluminum support is preferably subjected to a surface treatment for the purpose of enhancing the water retention and improving the adhesion with the photosensitive layer. Examples of the surface treatment include brushing, ball polishing, electrolytic etching, chemical etching, liquid honing, roughening treatment such as sand blasting, and combinations thereof. Among these, a roughening treatment including electrolytic etching is preferred.

In the electrolytic bath used during the electrolytic etching, an aqueous solution containing an acid, an alkali or a salt thereof, or an aqueous solution containing an organic solvent is used. Among these, an electrolytic solution containing hydrochloric acid, nitric acid, or a salt thereof is preferred.

If necessary, the aluminum support subjected to the roughening treatment is subjected to a desmutting treatment using an aqueous solution of an acid or alkali. The aluminum support thus obtained is preferably anodized. Particularly, an anodizing treatment performed in a bath containing sulfuric acid or phosphoric acid is preferred.

If necessary, the aluminum support can be subjected to silicate treatment (sodium silicate, potassium silicate), potassium zirconate fluoride treatment, phosphomolybdate treatment, alkyl titanate treatment, polyacrylate treatment, polyvinyl sulfonate treatment, phosphonate treatment, phytate treatment, treatment with a salt of a hydrophilic organic polymer compound and a divalent metal described in Japanese Patent Application, First Publication No. Sho 58-16839 and Japanese Patent Application, First Publication No. Sho 58-18291, hydrophilization treatment by undercoating of a water-soluble polymer having a sulfonic acid group described in Japanese Patent Application, First Publication No. Sho 59-101651, coloring treatment with an acidic dye described in Japanese Patent Application, First Publication No. Sho 60-64352, and treatment such as silicate deposition described in U.S. Patent No. 3,658,662.

Also the aluminum support subjected to a roughening treatment (graining treatment) or subjected to a sealing treatment after anodizing is preferred. The sealing treatment is performed by dipping the aluminum support in a hot water solution containing hot water and an inorganic or organic salt, or a steam bath.

The photosensitive planographic printing plate of the present invention is produced by applying a coating solution prepared by dissolving or dispersing a photosensitive composition in an organic solvent on the surface of a support, and drying the coating solution to form a photosensitive layer on the support.

As the organic solvent, in which the composition is dissolved or dispersed, there can be used any publicly known and conventional organic solvents. Among these, an organic solvent having a boiling point within a range from 40 to 200°C, and particularly from 60 to 160°C, is selected because of advantages during drying.

Examples of the organic solvent include alcohols such as methyl alcohol, ethyl alcohol, n- or isopropyl alcohol, n- or isobutyl alcohol and diacetone alcohol; ketones such as acetone, methyl ethyl ketone, methyl propyl ketone, methyl butyl ketone, methyl amyl ketone, methyl hexyl ketone, diethyl ketone, diisobutyl ketone, cyclohexanone, methylcyclohexanone and acetylacetone; hydrocarbons such as hexane, cyclohexane, heptane, octane, nonane, decane, benzene, toluene, xylene and methoxybenzene; acetate esters such as ethyl acetate, n- or isopropyl acetate, n- or isobutyl acetate, ethylbutyl acetate and hexyl acetate; halides such as methylene dichloride, ethylene dichloride and monochlorobenzene; ethers such as isopropyl ether, n-butyl ether, dioxane, dimethyldioxane and tetrahydrofuran; polyhydric alcohols and derivatives thereof, such as ethylene glycol, METHYL CELLOSOLVE®, METHYL CELLOSOLVE® acetate, ETHYL CELLOSOLVE®, DIETHYL CELLOSOLVE®, CELLOSOLVE® acetate, BUTYL CELLOSOLVE®, BUTYL CELLOSOLVE® acetate, methoxymethoxy ethanol, diethylene glycol monomethyl ether, diethylene glycol dimethyl ether, diethylene glycol methylethyl ether, diethylene glycol diethyl ether, propylene glycol, propylene glycol monomethyl ether, propylene glycol monomethyl ether acetate, propylene glycol monoethyl ether, propylene glycol monoethyl ether acetate, propylene glycol monobutyl ether, 3-methyl-3-methoxybutanol and 1-methoxy-2-propanol; and special solvents such as dimethyl sulfoxide, N,N-dimethylformamide, N,N-dimethylacetamide, methyl lactate and ethyl lactate. These organic solvents are used alone or in combination. The solid content in the coating is preferably controlled within a range from 2 to 50% by weight.

As the method of coating the coating solution, for example, there can be used roll coating, dip coating, air knife coating, gravure coating, gravure offset coating, hopper coating, blade coating, wire doctor coating and spray coating methods. The coating amount of the coating solution is preferably within a range from 10 to 100 ml/m².

The photosensitive composition applied on the support is usually dried by a heated air. The heating is preferably performed within a range from 30 to 200°C, and particularly preferably from 40 to 140°C. Not only the method of maintaining the drying temperature at the same temperature during drying, but also the method of raising the temperature stepwise can also be carried out.

Preferred results are obtained, sometimes, by dehumidification of the drying air. The dried air is preferably supplied to the surface to be coated at a rate within a range from 0.1 to 30 m/sec, and particularly preferably from 0.5 to 20 m/sec.

The coating weight of the photosensitive composition is usually within a range from about 0.5 to 5 g/m² on a dry basis.

The photosensitive planographic printing plate having a photosensitive layer made of each of the photosensitive compositions (1) to (3) is converted into a planographic printing plate having a corresponding image formed on the support by exposing the photosensitive layer to light in the state of being in close contact with a silver salt mask film and developing with a developer, thereby to dissolve and remove the non-image area.

Examples of the preferred light source used in the exposure include a carbon arc lamp, mercury lamp, metal halide lamp, xenon lamp, chemical lamp and laser.

The photosensitive planographic printing plate made of each of the photosensitive compositions (3) to (5) can be used as a so-called computer-to-plate (CTP) which can directly write an image on a plate based on digital information from the computer using laser.

Examples of the laser light sources include lasers that emits light in an ultraviolet, visible or infrared range having a wavelength within a range from 300 to 3000 nm. Specific examples thereof include Ar ion laser (488 nm, 515 nm), FD-YAG laser (532 nm), He-Ne laser (633 nm, 543 nm, 364 nm), InGaN semiconductor laser (360 to 450 nm, particularly 405 nm), various semiconductor lasers wherein an oscillation wavelength is within a range from 760 to 950 nm and YAG laser (oscillation wavelength 1064 nm). Any laser can be used by selecting the pigment or dye, which can absorb light having a specific wavelength of the light source to convert light into heat, or a sensitizing pigment among those described above and adding it in the photosensitive composition.

The photosensitive planographic printing plate is converted into a planographic printing plate having an image area by writing an image on a photosensitive layer using a laser, subjecting to a developing treatment and removing the non-image area using a wet method. Examples of the developer used in the developing treatment include an aqueous alkali solution (basic aqueous solution).

Examples of the alkali agent used in the developer include inorganic alkali compounds such as sodium silicate, potassium silicate, potassium hydroxide, sodium hydroxide, lithium hydroxide, sodium, potassium or ammonium salt of secondary or tertiary phosphoric acid, sodium metasilicate, sodium carbonate and ammonia; and organic alkali compounds such as monomethylamine, dimethylamine, trimethylamine, monoethylamine, diethylamine, triethylamine, monoisopropylamine, diisopropylamine, n-butylamine, di-n-butylamine, monoethanolamine, diethanolamine, triethanolamine, ethyleneimine and ethylenediamine.

The content of the alkali agent in the developer is preferably within a range from 0.005 to 30% by weight, and particularly preferably from 0.05 to 15% by weight. When the content of the alkali agent in the developer is less than 0.005% by weight, the development tends to be poor. On the other hand, when the amount is more than 30% by weight, an adverse influence such as corrosion of the image area tends to be exerted during the development. Therefore, it is not preferred.

An organic solvent can be added in the developer. Examples of the organic solvent, which can be added in the developer, include ethyl acetate, butyl acetate, amyl acetate, benzyl acetate, ethylene glycol monobutyl acetate, butyl lactate, butyl levulinate, methyl ethyl ketone, ethyl butyl ketone, methyl isobutyl ketone, cyclohexanone, ethylene glycol monobutyl ether, ethylene glycol monobenzyl ether, ethylene glycol monophenyl ether, benzyl alcohol, methyl phenyl carbitol, n-amyl alcohol, methylamyl alcohol, xylene, methylene dichloride, ethylene dichloride and monochlorobenzene.

The amount of the organic solvent to be added in the developer is preferably 20% by weight or less, and particularly preferably 10% by weight or less.

In the developer, there can be optionally used various surfactants and defoamers, for example, water-soluble sulfites such as lithium sulfite, sodium sulfite, potassium sulfite and magnesium sulfite; aromatic hydroxy compounds such as alkali-soluble pyrazolone compound, alkali-soluble thiol compound and methyl resorcinol; water softeners such as polyphosphate and aminopolycarboxylate; and anionic surfactants, nonionic surfactants, cationic surfactants, amphoteric surfactants and fluorosurfactants such as sodium isopropylnaphthalene sulfonate, sodium n-butylnaphthalene sulfonate, sodium N-methyl-N-pentadecyl aminoacetate and sodium lauryl sulfate.

As the developer, commercially available developers for positive or negative-working PS plate can be practically used. Specifically, a developer prepared by diluting a commercially available concentrated developer for positive or negative-working PS plate 1 to 200 times can be used as the developer in the present invention.

The temperature of the developer is preferably from 15 to 40°C, while the dipping time is preferably from 1 second to 5 minutes. If necessary, it is possible to slightly rub the surface during the development.

After the completion of the development, the planographic printing plate is subjected to washing with water and/or a treatment with an aqueous desensitizer (finishing gum). The aqueous desensitizer includes, for example, an aqueous solution of a water-soluble natural polymer such as gum arabic, dextrin or carboxymethylcellulose, or a water-soluble synthetic polymer such as polyvinyl alcohol, polyvinyl pyrrolidone or polyacrylic acid. If necessary, an acid or a surfactant is added in the aqueous desensitizer. After subjecting to the treatment with the desensitizer, the planographic printing plate is dried and then used as a printing plate in the printing.

As described above, the photosensitive planographic printing plate comprises a support and a photosensitive layer made of the photosensitive composition provided on the surface of the support and the photosensitive composition contains both a fluorosurfactant and/or a silicone surfactant and an acrylic polymer having a monomer unit of the general formula (1) and, therefore, the receptivity of oil-based ink is improved and inking properties are improved. Furthermore, uniform thickness of the photosensitive layer makes light exposure and development uniform and an improvement in reproducibility of the original pattern allows uniform printing, resulting in improved printing quality.

### EXAMPLES

The present invention will be described in more detail by way of examples, but the present invention is not limited to the following examples. In the examples, percentages are by weight unless otherwise specified.

### Aluminum support

An aluminum sheet having a thickness of 0.24 mm and a width of 1030 mm was degreased with an aqueous sodium hydroxide and then electrolytically polished in a 20% hydrochloric acid bath to obtain a grained sheet having a center line average roughness (Ra) of 0.5 µm. The resulting grained sheet was anodized in a 20% sulfuric acid bath at a current density of 2 A/dm² to form an oxide film of 2.7 g/m², which was washed with water and then dried to obtain an aluminum substrate.

### Acrylic copolymer A

An acrylic copolymer A is a tert-butyl methacrylate/ethyl methacrylate (EMA) copolymer wherein R⁴ in the general formula (2) is only an alkyl group. With respect to the weight percentage of the monomer unit of the acrylic copolymer A, tert-butyl methacrylate/EMA is 85/15.

The process for producing the acrylic copolymer A is as follows. First, 170.0 g of METHYL CELLOSOLVE® was charged in a reaction vessel equipped with a stirrer and a reflux condenser under a nitrogen gas flow, and then heated to 80°C. In the reaction vessel, a mixture containing 68 g of tert-butyl methacrylate, 12 g of ethyl methacrylate, 3.20 g of azoisobutyronitrile and 16.7 g of METHYL CELLOSOLVE® was added dropwise over 2 hours. After the completion of dropwise addition, the reaction was further continued for 2 hours while maintaining the temperature to synthesize an acrylic copolymer A. The acrylic copolymer A was used in the form of a 10 wt% solution after diluting with METHYL CELLOSOLVE®.

### Acrylic copolymer B

An acrylic copolymer B is obtained by adding 5 moles of ε-caprolactone to hydroxyl groups of a hydroxyethyl methacrylate unit. That is, it is a copolymer of a monomer wherein R² in the general formula (1) is a polyester chain and a monomer wherein R⁴ in the general formula (2) is an alkyl group.

The process for producing the acrylic copolymer B is as follows. First, 170.0 g of METHYL CELLOSOLVE® was charged in a reaction vessel equipped with a stirrer and a reflux condenser under a nitrogen gas flow, and then heated to 80°C. In the reaction vessel, a mixture containing 68 g of tert-butyl methacrylate, 12 g of hydroxyethyl methacrylate, 3.20 g of azoisobutyronitrile and 16.7 g of ETHYL CELLOSOLVE® was added dropwise over 2 hours. After the completion of dropwise addition, the reaction was further continued for 2 hours while maintaining the temperature. The reaction solution was charged in water to deposit a polymer component, which was collected by filtration and then dried to obtain a powdered polymer. The powdered polymer, ε-caprolactone (total amount of the powdered polymer and ε-caprolactone is 24.9 g, powdered polymer/ε-caprolactone = 1/5), dimethylacetamide and dibutyltin dilaurate were charged in a reaction vessel equipped with a stirrer and a reflux condenser, and then stirred while maintaining at 160°C under a nitrogen gas flow. The reaction was continued for 8 hours at the same temperature to synthesize an acrylic copolymer B. The acrylic copolymer B was used in the form of a 10 wt% solution after diluting with METHYL CELLOSOLVE®.

### Acrylic copolymer C

An acrylic copolymer C is a copolymer of tert-butyl methacrylate and a polyether chain-containing monomer represented by the following chemical formula (3). That is, it is a copolymer of a monomer wherein R² in the general formula (1) is a polyether chain and a monomer wherein R⁴ in the general formula (2) is an alkyl group. With respect to the weight percentage of the monomer unit, tert-butyl methacrylate/polyether chain-containing monomer is 80/20.

The process for producing the acrylic copolymer C is as follows. First, 170.0 g of METHYL CELLOSOLVE® was charged in a reaction vessel equipped with a stirrer and a reflux condenser under a nitrogen gas flow, and then heated to 80°C. In the reaction vessel, a mixture containing 64 g of tert-butyl methacrylate, 16 g of a polyether chain-containing monomer, 3.20 g of azoisobutyronitrile and 16.7 g of METHYL CELLOSOLVE® was added dropwise over 2 hours. After the completion of dropwise addition, the reaction was further continued for 2 hours while maintaining the temperature to synthesize an acrylic copolymer C. The acrylic copolymer C was used in the form of a 10 wt% solution after diluting with METHYL CELLOSOLVE®.

CH₂ = C (CH₃) CO (OC₂H₄)₇ - OCH₃ **Chemical Formula (3)**

### Surfactant, Organic dye

Megafac F-177 (30% solution) manufactured by DAINIPPON INK & CHEMICALS Inc. was used as a fluorosurfactant, BYK-333 (10% solution) manufactured by BYK Chemie was used as a silicone surfactant, and Victoria Pure Blue BOH manufactured by Hodogaya Chemical Co., Ltd., was used as an organic dye.

### Diazo compound-containing negative-working photosensitive planographic printing plate

On an aluminum support, a coating solution containing a photosensitive composition shown in Table 1 was continuously applied, and then dried by blowing a hot air in a drying zone at 110°C for one minute to form a photosensitive layer, and thus a diazo compound-containing photosensitive planographic printing plate was obtained. The weight of the dry coating film was 1.6 g/m². In the photosensitive composition shown in Table 1, a surfactant and an acrylic copolymer were mixed in a proportion shown in Table 2.

With respect to the photosensitive planographic printing plate thus obtained, uniformity and inking properties of the dry coating film were determined. The procedures for the measurement will be described below.

**Table 1**

| | Weight | Proportion |
|---|---|---|
| | (g) | (% by weight) |
| 2-hydroxyethyl methacrylate copolymer (the same as those of Example 1 of Japanese Patent Application, First Publication No. Sho 50-118802) | 11.40 | 11.5 |
| 2-methoxy-4-hydroxy-5-benzoyl benzenesulfonate as a condensate of p-diazodiphenylamine and formaldehyde | 1.00 | 1.0 |
| Surfactant and acrylic polymer | 0.45 | 0.45 |
| Organic dye | 0.11 | 0.11 |
| METHYL CELLOSOLVE® | 48.00 | 48.5 |
| Methanol | 10.00 | 10.1 |
| Methyl ethyl ketone | 28.00 | 28.3 |

### Uniformity of dry coating film

With respect to the dry coating film, unevenness caused by drying air flow and linear irregularities that occurred upon coating in the coating film were evaluated by visual inspection. The results are shown in Table 2. In the table, samples where the resulting coating film was uniform and free from irregularity were rated "A", samples where the coating film was slightly irregular were rated "B", samples where the coating film was irregular as a result of drying air blowing were rated "C", and samples where the coating film was drastically irregular as a result of drying air blowing were rated "D".

### Inking properties

Using a planographic printing plate obtained by proper light exposure, development and gumming, printing was conducted by a planographic printing press R-700 (from Man Roland) and inking properties were evaluated by the number of printed sheets required to completely transfer ink to a printing paper at the beginning of printing. The results are shown in Table 2. In the table, samples where the number of printed sheets was less than 10 were rated A", samples where the number of printed sheets was from 10 to 20 were rated "B", and samples where the number of printed sheets exceeded 20 were rated "C".

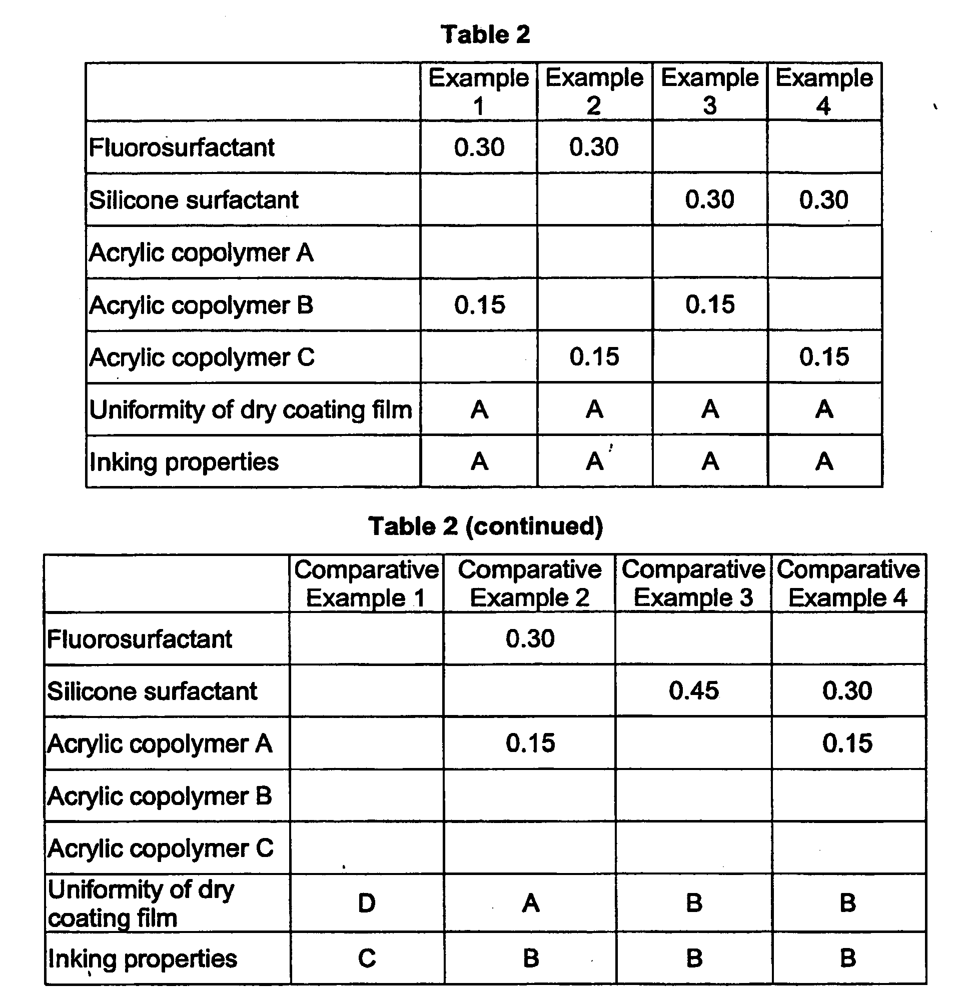

Because the photosensitive planographic printing plates of Examples 1 to 4 comprise a photosensitive layer made of a photosensitive composition containing a fluorosurfactant or a silicone surfactant and an acrylic polymer having a polyester or polyether chain, the film thickness was very uniform and inking properties were excellent.

Moreover, an original film was adhered to the photosensitive planographic printing plates of Examples 1 to 4 and, after the completion of light exposure, development was conducted by an automatic developing machine for negatives. As a result, the sensitivity and the reproducibility of the original pattern were excellent.

On the other hand, because the photosensitive planographic printing plate of Comparative Example 1 contains neither the fluorosurfactant or silicone surfactant, nor the acrylic copolymer of the general formula (1), the uniformity of the coating film was poor and also inking properties were poor.

Although the photosensitive planographic,printing plate of Comparative Example 2 contains the fluorosurfactant, the acrylic copolymer does not contain the polyester or polyether chain, and thus inking properties were poor.

Because the photosensitive planographic printing plate of Comparative Example 3 does not contain the acrylic polymer, the uniformity of the coating film was poor and also inking properties were poor.

Although the photosensitive planographic printing plate of Comparative Example 4 contains the silicone surfactant, the acrylic copolymer does not contain the polyester or polyether chain, inking properties were poor.

### Photopolymerized diazo compound composite-based photosensitive planographic printing plate

On an aluminum support, a coating solution containing a photosensitive composition shown in Table 3 was continuously applied, and then dried by blowing a hot air in a drying zone at 110°C for one minute to form a photosensitive layer, and thus a photopolymerized diazo compound composite-based photosensitive planographic printing plate was obtained. The weight of the dry coating film was 1.3 g/m². In the photosensitive composition shown in Table 3, a surfactant and an acrylic copolymer were mixed in a proportion shown in Table 4.

With respect to the resulting photopolymerized diazo compound composite-based photosensitive planographic printing plate, uniformity and inking properties of the dry coating film were determined. The results are shown in Table 4.

**Table 3**

| | Weight | Proportion |
|---|---|---|
| | (g) | (% by weight) |
| Copolymer having a methacryloyl group in the side chain (the same as a polymer-1 of Japanese Patent Application, First Publication No. Sho 10-282658) | 5.00 | 51 |
| Alkyl naphthalenesulfonate as a condensate of p-diazodiphenylamine and formaldehyde | 0.45 | 0.45 |
| Dipentaerythritol hexaacrylate | 1.70 | 1.70 |
| 2-(4-methoxynaphthyl)-4,6-bis(trichloromethyl)-s-triazine | 0.18 | 0.18 |
| Surfactant and acrylic polymer | 0.12 | 0.12 |
| Organic dye | 0.13 | 0.13 |
| METHYL CELLOSOLVE® | 45.0 | 45.6 |
| Methanol | 9.90 | 10.0 |
| Methyl ethyl ketone | 36.22 | 36.74. |

**Table 4**

| | Example 5 | Example 6 | Example 7 | Comparative Example 5 | Comparative Example 6 |
|---|---|---|---|---|---|
| Fluorosurfactant | 0.08 | | | 0.08 | |
| Silicone surfactant | | 0.08 | 0.08 | | 0.12 |
| Acrylic copolymer A | | | | 0.04 | |
| Acrylic copolymer B | 0.04 | 0.04 | 0.04 | | |
| Acrylic copolymer C | | | | | |
| Uniformity of dry coating film | A | A | A | A | B |
| Inking properties | A | A | A | B | B |

Because the photosensitive planographic printing plates of Examples 5 to 7 comprise a photosensitive layer made of a photosensitive composition containing a fluorosurfactant or a silicone surfactant and an acrylic polymer having a polyester or polyether chain, the film thickness was very uniform and also inking properties were excellent.

Moreover, an original film was adhered to the photosensitive planographic printing plates of Examples 5 to 7 and, after the completion of light exposure, development was conducted by an automatic developing machine for negative. As a result, the sensitivity and the reproducibility of the original pattern were excellent.

Although the photosensitive planographic printing plate of Comparative Example 5 contains the fluorosurfactant, the acrylic copolymer does not contain the polyester or polyether chain, and thus inking properties were poor.

Because the photosensitive planographic printing plate of Comparative Example 6 contains only the silicone surfactant, and thus uniformity of the coating film was poor and also inking properties were poor.

### General-purpose positive-working photosensitive planographic printing plate

On an aluminum support, a coating solution containing a photosensitive composition shown in Table 5 was continuously applied, and then dried by blowing a hot air in a drying zone at 110°C for one minute to form a photosensitive layer, and thus a general-purpose positive-working photosensitive planographic printing plate was obtained. The weight of the dry coating film was 2.0 g/m². In the photosensitive composition shown in Table 5, a surfactant and an acrylic copolymer were mixed in a proportion shown in Table 6.

With respect to the resulting general-purpose positive-working photosensitive planographic printing plate, uniformity and inking properties of the dry coating film were determined. The results are shown in Table 6.

**Table 5**

| | Weight (g) | Proportion (% by weight) |
|---|---|---|
| M/p-cresol-formaldehyde resin (m/p = 6/4, Mw = 5000) | 16.00 | 16.1 |
| Esterified product of 1,2-naphthoquinonediazide-5-sulfonyl chloride and 2,3,4-trihydroxybenzophenone | 3.00 | 3.0 |
| 2-(4-methoxynaphthyl)-4,6-(bis(trichloromethyl)-s-triazine) | 0.06 | 0.06 |
| Surfactant and acrylic polymer | 0.45 | 0.45 |
| Organic dye | 0.14 | 0.14 |
| METHYL CELLOSOLVE® | 34.0 | 34.1 |
| Methanol | 10.0 | 10.0 |
| Methyl ethyl ketone | 36.0 | 36.1 |

**Table 6**

| | Example 8 | Example 9 | Comparative Example 7 | Comparative Example 8 |
|---|---|---|---|---|
| Fluorosurfactant | 0.30 | | | |
| Silicone surfactant | | 0.30 | 0.30 | |
| Acrylic copolymer A | | | 0.15 | |
| Acrylic copolymer B | 0.15 | 0.15 | | |
| Uniformity of dry coating film | A | A | B | D |
| Inking properties | A | A | B | C |

Because the photosensitive planographic printing plate of Examples 8 or 9 comprises a photosensitive layer made of a photosensitive composition containing a fluorosurfactant or a silicone surfactant and an acrylic polymer having a polyester or polyether chain, the film thickness was very uniform and also inking properties were excellent.

Moreover, the photosensitive planographic printing plate of Example 8 or 9 was superior in press-life and image intensity.

Although the photosensitive planographic printing plate of Comparative Example 7 contains the silicone surfactant, the acrylic copolymer does not contain the polyester or polyether chain, and thus uniformity of the coating film was poor and also inking properties were poor.

Because the photosensitive planographic printing plate of Comparative Example 8 contains neither the fluorosurfactant or the silicone surfactant, nor the acrylic copolymer having the polyester or polyether chain, and thus uniformity of the coating film was poor and also inking properties were poor.

### Positive-working photosensitive planographic printing plate capable of being activated by infrared laser

On an aluminum support, a coating solution containing a photosensitive composition shown in Table 7 was continuously applied, and then dried by blowing a hot air in a drying zone at 110°C for one minute to form a photosensitive layer, and thus a positive-working photosensitive planographic printing plate capable of being activated by infrared laser was obtained. The weight of the dry coating film was 2.0 g/m². In the photosensitive composition shown in Table 7, a surfactant and an acrylic copolymer were mixed in a proportion shown in Table 8.

With respect to the resulting positive-working photosensitive planographic printing plate, uniformity and inking properties of the dry coating film were determined. The results are shown in Table 8.

**Table 7**

| | Weight (g) | Proportion (% by weight) |
|---|---|---|
| m/p-cresol-formaldehyde resin (m/p = 6/4, Mw = 5000) | 10.0 | 10.0 |
| IR Dye A (manufactured by Eastman Kodak) (see structure below) | 0.20 | 0.20 |
| Surfactant and acrylic polymer | 0.15 | 0.15 |
| Crystal Violet | 0.20 | 0.20 |
| METHYL CELLOSOLVE® | 74.0 | 74.2 |
| Methanol | 15.15 | 15.2 |

**Table 8**

| | Example 10 | Example 11 | Comparative Example 9 | Comparative Example 10 |
|---|---|---|---|---|
| Fluorosurfactant | 0.10 | | | |
| Silicone surfactant | | 0.10 | 0.10 | |
| Acrylic copolymer A | | | 0.05 | |
| Acrylic copolymer B | 0.05 | 0.05 | | |
| Uniformity of dry coating film | A | A | A | D |
| Inking properties | A | A | B | B |

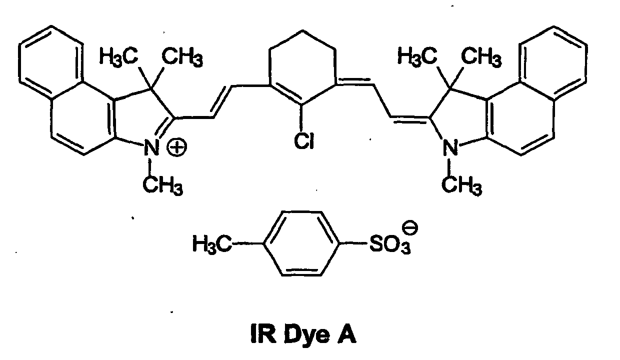

Because the photosensitive planographic printing plate of Examples 10 or 11 comprises a photosensitive layer made of a photosensitive composition containing a fluorosurfactant or a silicone surfactant and an acrylic polymer having a polyester or polyether chain, the film thickness was very uniform and inking properties were excellent.

Moreover, the photosensitive planographic printing plate of Example 10 or 11 was superior in press-life and image intensity.

Although the photosensitive planographic printing plate of Comparative Example 9 contains the silicone surfactant, the acrylic copolymer does not contain the polyester or polyether chain, and thus inking properties were poor.

Because the photosensitive planographic printing plate of Comparative Example 10 contains neither the fluorosurfactant or the silicone surfactant, nor the acrylic copolymer having the polyester or polyether chain, the uniformity of the coating film was poor and also inking properties were poor. Moreover, severe irregularity occurred on the surface of the planographic printing plate.

### Effects of the Invention

According to the present invention, the wettability on the support is improved by the fluorosurfactant or the silicone surfactant and leveling properties are improved by the acrylic polymer having the polyester or polyether chain, and therefore the thickness of the photosensitive layer can be made extremely uniform. Furthermore, uniform thickness of the photosensitive layer makes light exposure and development uniform and an improvement in reproducibility of the original pattern allows uniform printing, resulting in improved printing quality. The oil-based ink receptivity is improved by mixing the fluorosurfactant or silicone surfactant and the acrylic polymer having a polyester or polyether chain, and therefore inking properties are improved.

## Claims

1. A photosensitive composition comprising:
a silicone surfactant or a fluorosurfactant, and
an acrylic copolymer comprising a monomer unit represented by:
- [CH₂-CF¹ (COOR²) -]ₙ-
wherein:
R¹ is H or CH₃, and
R² is a polyester or polyether chain.

2. The photosensitive composition of claim 1 wherein the acrylic polymer additionally comprises a monomer unit represented by:
- [CH₂-CR³ (COOR⁴) -]ₙ-
wherein:
R³ represents H or CH₃, and
R⁴ represents an alkyl or phenylalkylene group having 1 to 30 carbon atoms.

3. The photosensitive composition of claim 1 or 2 wherein the polyester or polyether chain has a molecular weight of 200 to 3000.

4. The photosensitive composition of any one of claims 1 to 3 further comprising an o-quinonediazide compound.

5. The photosensitive composition of any one of claims 1 to 3 further comprising a photosensitive diazonium compound.

6. The photosensitive composition of any one of claims 1 to 3 further comprising an ethylenically unsaturated compound and a radical polymerization initiator.

7. The photosensitive composition of any one of claims 1 to 3 further comprising a photothermal converting agent.

8. The photosensitive composition of any one of claims 1 to 3 further comprising a compound that generates an acid by heat, an acid crosslinking agent, and a photothermal converting agent.

9. A photosensitive planographic printing plate precursor comprising a support and a photosensitive layer comprising the photosensitive composition of any one of claims 1 to 8 on the surface of the support.

10. A method for forming an image, the method comprising the steps of imaging and developing the photosensitive planographic printing plate precursor of claim 9.

## Patentansprüche

1. Eine fotoempfindliche Zusammensetzung, umfassend:
ein Silicontensid oder ein Fluortensid und
ein Acrylcopolymer, umfassend eine Monomereinheit, dargestellt durch:
-[CH₂-CR¹(COOR²)-]ₙ-
wobei:
R¹ für H oder CH₃ steht und
R² eine Polyester- oder Polyetherkette ist.

2. Die fotoempfindliche Zusammensetzung nach Anspruch 1, wobei das Acrylpolymer zusätzlich eine Monomereinheit, dargestellt durch:
-[CH₂-CR³(COOR⁴)-]ₙ-
umfasst, wobei:
R³ für H oder CH₃ steht und
R⁴ einen Alkyl- oder Phenylalkylenrest mit 1 bis 30 Kohlenstoffatomen bedeutet.

3. Die fotoempfindliche Zusammensetzung nach Anspruch 1 oder 2, wobei die Polyester- oder Polyetherkette ein Molekulargewicht von 200 bis 3000 aufweist.

4. Die fotoempfindliche Zusammensetzung nach einem der Ansprüche 1 bis 3, weiter umfassend eine o-Chinondiazid-Verbindung.

5. Die fotoempfindliche Zusammensetzung nach einem der Ansprüche 1 bis 3, weiter umfassend eine fotoempfindliche Diazoniumverbindung.

6. Die fotoempfindliche Zusammensetzung nach einem der Ansprüche 1 bis 3, weiter umfassend eine ethylenisch ungesättigte Verbindung und einen Initiator für radikalische Polymerisation.

7. Die fotoempfindliche Zusammensetzung nach einem der Ansprüche 1 bis 3, weiter umfassend einen fotothermischen Umwandler.

8. Die fotoempfindliche Zusammensetzung nach einem der Ansprüche 1 bis 3, weiter umfassend eine Verbindung, die durch Wärme eine Säure erzeugt, ein durch Säure vernetzendes Mittel und einen fotothermischen Umwandler.

9. Ein fotoempfindlicher Flachdruckplatten-Vorläufer, umfassend einen Träger und eine fotoempfindliche Schicht, welche die fotoempfindliche Zusammensetzung nach einem der Ansprüche 1 bis 8 umfasst, auf der Oberfläche des Trägers.

10. Ein Verfahren zum Erzeugen eines Bildes, wobei das Verfahren die Schritte des Bebilderns und Entwickelns des fotoempfindlichen Flachdruckplatten-Vorläufers nach Anspruch 9 umfasst.

## Revendications

1. Composition photosensible comprenant :
un agent tensioactif siliconé ou un agent tensioactif fluoré, et
un copolymère acrylique comprenant un motif monomère représenté par la formule :
-[CH₂-CR¹(COOR²) -]ₙ-
où :
R¹ est H ou CH₃ ; et
R² est une chaîne polyester ou polyéther.

2. Composition photosensible selon la revendication 1, dans laquelle le polymère acrylique comprend en outre un motif monomère représenté par la formule :
-[CH₂-CR³ (COOR⁴) -]ₙ-
où :
R³ est H ou CH₃ ; et
R⁴ représente un groupe alkyle ou phénylalkylène de 1 à 30 atomes de carbone.

3. Composition photosensible selon la revendication 1 ou la revendication 2, dans laquelle la chaîne polyester ou polyéther a un poids moléculaire de 200 à 3000.

4. Composition photosensible selon l'une quelconque des revendications 1 à 3 comprenant en outre un composé o-quinonediazide.

5. Composition photosensible selon l'une quelconque des revendications 1 à 3 comprenant en outre un composé photosensible diazonium.

6. Composition photosensible selon l'une quelconque des revendications 1 à 3 comprenant en outre un composé à insaturation éthylénique et un initiateur de polymérisation par voie radicalaire.

7. Composition photosensible selon l'une quelconque des revendications 1 à 3 comprenant en outre un agent de conversion photothermique.

8. Composition photosensible selon l'une quelconque des revendications 1 à 3 comprenant en outre un composé générant un acide sous l'action de la chaleur, un agent réticulant acide et un agent de conversion photothermique.

9. Précurseur de plaque d'impression planographique photosensible comprenant un support et une couche photosensible contenant la composition photosensible selon l'une quelconque des revendications 1 à 8, sur la surface du support.

10. Procédé de formation d'une image, ledit procédé comprenant les étapes de formation d'image et de développement du précurseur de plaque d'impression planographique photosensible de la revendication 9.
